# DEMANDE DE BREVET EUROPEEN

(11) **EP 0 667 735 A1**
(43) Date de publication de la demande: **16.08.1995**
(21) Numéro de dépôt: 95810031.5
(22) Date de dépôt: 16.01.1995
(51) Int. Cl.: H05K 1/00, G12B 11/02

(54) **Cadran électro-mécanique**

(30) Priorité: 11.02.1994 CH 455/94
(71) Demandeur: Artho, Félix, CH-2926 Boncourt (CH); Baumann, Henri, CH-2800 Delemont (CH)
(72) Inventeur: Artho, Félix, CH-2926 Boncourt (CH); Baumann, Henri, CH-2800 Delemont (CH)

(57) **Abrégé**

Le cadran d'un appareil est utilisé comme support pour les composants électriques et mécaniques.

Ses propriétés électriques servent au foncionne- ment de l'instrument.

## Description

Par l'application de couches conductrices et isolantes, le cadran est utilisé comme une base de circuit imprimé dont il peut déterminer un des pôle.

Le cadran est utilisé comme support pour les composants électriques et mécaniques.

Ses propriétés électriques servent au foncion- nement de l'instrument.

Le cadran conserve ses fonctions originales.

## Revendications

Utilisation des propriétés électro-mécaniques du cadran pour le fonctionnement de l'appareil dont il sert d'affichage.
1. La fabrication actuelle d'instrument électronique à cadran nécessite une plaque de base (circuit imprimé) dont les fonction sont à la fois mécaniques et électriques.
Grâce à l'évolution technologique il est possible d'utiliser les propriétés mécaniques et électriques du cadran lui-même.
Ceci permet d'éliminer la plaque de base précédemment nécessaire, de diminuer le volume (donc la masse) et de réduire le temps d'assemblage.
